# EUROPEAN PATENT SPECIFICATION

(11) **EP 1 868 230 B1**
(45) Date of publication and mention of the grant of the patent: **23.10.2013**
(21) Application number: 06731026.8
(22) Date of filing: 04.04.2006
(51) Int. Cl.: H01L 21/02, H01L 21/304, H01L 27/12, H01L 21/762, H01L 21/20

(54) **MANUFACTING METHOD OF SOI WAFER AND SOI WAFER MANUFACTURED BY THIS METHOD**
SOI-WAFER-HERSTELLUNGSVERFAHREN UND DADURCH HERGESTELLTER SOI-WAFER
PROCEDE DE FABRICATION D' UNE GALETTE SOI ET GALETTE SOI AINSI FABRIQUEE

(30) Priority: 06.04.2005 JP 2005110019
(43) Date of publication of application: 19.12.2007
(73) Proprietor: Shin-Etsu Handotai Co., Ltd., Tokyo (JP)
(72) Inventor: SOETA, Yasutsugu, Yokonodaira Plant, Shin-Etsu, Annaka-shi, Gunma 3790125 (JP); NAGAOKA, Yasuo, Yokonodaira Plant, Shin-Etsu, Annaka-shi, Gunma 3790125 (JP)
(74) Representative: Wibbelmann, Jobst
(86) International application number: PCT/JP2006/307078
(87) International publication number: WO 2006/109614

(56) References cited:
- EP-A1- 0 971 396
- EP-A1- 1 045 448
- EP-A2- 1 480 265
- JP-A- 2000 091 279
- JP-A- 2004 259 970
- US-A1- 2004 241 958

## Description

### Technical Field

The present invention relates to a method of removing a damaged layer remaining on an SOI layer after delamination and improving a flatness (a difference between a maximum thickness and a minimum thickness) and in-plane film thickness distribution after polishing the SOI layer in an SOI (Silicon On Insulator) wafer manufacturing method by ion implantation delamination method.

### Background Art

A technology which is a so-called ion implantation delamination method (a smart cut method) for delaminating an ion-implanted wafer after bonding to manufacture an SOI wafer is disclosed as a manufacturing method of an SOI wafer. This method is a technology of forming an oxide film on at least one of two silicon wafers, implanting an hydrogen ion or a rare gas ion from an upper surface of one silicon wafer to form a micro bubble layer (an ion-implanted layer) in the wafer, then bringing the ion-implanted surface into close contact with the other silicon wafer via the oxide film, subsequently performing a heat treatment (a delamination heat treatment) to delaminate one of the wafers in the form of a thin film with the micro bubble layer being determined as a cleavage plane, and further conducting a heat treatment (a bonding heat treatment) in some cases to firmly bond the wafer, thereby providing an SOI wafer (see Japanese Patent Application Laid-open (kokai) No. 5-211128).

According to this method, the cleavage plane (a delaminated plane) is an excellent mirror surface, and the SOI wafer having high uniformity of a film thickness of an SOI layer is relatively easily obtained. However, when fabricating the SOI wafer by the ion implantation delamination method, a damaged layer is present on an SOI wafer surface after delamination due to ion implantation, surface roughness is higher than that of a mirror surface of a regular silicon wafer, and unevenness occurs in a film thickness distribution of the SOI layer. Therefore, in the ion implantation delamination method, such a damaged layer or surface roughness must be removed.

In order to remove this damaged layer and others, mirror polishing called touch polishing with a very small removal stock has been conventionally carried out at a final step after the bonding heat treatment; such as described in document EP 1045 448 A1. However, when the SOI layer is subjected to polishing which is machining, since a removal stock in polishing is not uniform, there arises a problem that film thickness uniformity of the SOI layer achieved by hydrogen ion implantation and delamination is degraded.

Thus, a method of removing the damaged layer by conducting so-called sacrificial oxidation, in which a heat treatment in an oxidizing atmosphere with respect to an SOI wafer after delamination is performed to form an oxide film on the SOI layer and then the oxide film is removed, has been proposed. This method can remove the damaged layer without carrying out polishing as machining.

However, since performing this sacrificial oxidation alone cannot sufficiently improve surface roughness of an SOI layer surface, touch polishing as mechanical polishing is eventually required to improve surface roughness, and again there occurs a problem that a flatness of an SOI wafer and film thickness uniformity of the SOI layer are degraded.

### Disclosure of the Invention

Thus, the present invention was accomplished in view of the above-explained problem, and it is an object of the present invention to provide, in an ion implantation delamination method, a method of manufacturing a high-quality SOI wafer which can remove a damaged layer and surface roughness remaining on an SOI layer surface after delamination while maintaining film thickness uniformity of the SOI layer without degrading a film thickness distribution and a flatness even if the surface of the SOI layer is polished, and to improve productivity in wafer manufacture.

To achieve this object, according to the present invention, there is provided a manufacturing method of an SOI wafer by an ion implantation delamination method, comprising at least: forming an oxide film on a surface of at least one of a base wafer serving as a support substrate and a bond wafer functioning as an SOI layer; implanting at least one of a hydrogen ion and a rare gas ion from a surface of the bond wafer to form an ion implanted layer; subsequently bringing the bond wafer into close contact with the base wafer via the oxide film; performing a heat treatment to cause delamination in the ion implanted layer so that the SOI layer is formed; then conducting a heat treatment in an oxidizing atmosphere to form an oxide film on the surface of the SOI layer; subsequently removing the oxide film by etching; then cleaning the surface of the SOI layer by using ozone water; and polishing the surface of the SOI layer.

As explained above, according to the method of manufacturing the SOI wafer by the ion implantation delamination method, when the surface of the SOI layer is cleaned by using ozone water before the step of polishing the SOI layer surface, a film thickness distribution of a native oxide film on the SOI layer surface before polishing is degraded as compared with an example where acid cleaning (e.g., SC-2 cleaning) is carried out like a conventional technology, but this has the opposite effect of spreading abrasive grains on the entire polished surface at the time of polishing, the film thickness distribution and the flatness after polishing are improved, and the high-quality SOI wafer can be efficiently obtained, thereby enhancing productivity.

At this time, a heat treatment to increase bonding strength may be carried out at a temperature higher than that in the delamination heat treatment after the delamination heat treatment.
As explained above, when the heat treatment is carried out with respect to the bonded wafer at a temperature higher than that in the delamination heat treatment after the delamination heat treatment, the bonding strength of the SOI layer (a bond wafer) and a support substrate (a base wafer) can be increased. Of course, a delamination heat treatment temperature may be set to a higher temperature so that this heat treatment can also function as a bonding heat treatment.

Further, it is desirable that the removal of the oxide film by the etching is performed by using an aqueous solution containing a hydrogen fluoride.
When the removal of the oxide film by the etching is performed by using the aqueous solution containing the hydrogen fluoride in this manner, the oxide film alone can be etched, and the damaged layer remaining on the surface of the SOI layer can be readily removed by sacrificial oxidation.

Furthermore, it is desirable that an ozone concentration in the ozone water is 3 ppm or more and 10 ppm or less.
When the ozone concentration in the ozone water is 3 ppm or more and 10 ppm or less in this manner, cleaning using this ozone water enables appropriately to degrade the film thickness distribution of the native oxide film on the surface of the SOI layer as compared with the conventional acid cleaning, and subsequent polishing enables to obtain the SOI layer having the uniform film thickness distribution.

Moreover, it is desirable that the polishing is carried out by touch polishing.
When the polishing is carried out by touch polishing, the wafer can be subjected to mirror polishing with a very small removal stock, and flattening can be carried out without degrading the film thickness distribution as much as possible, thereby obtaining the high-quality SOI wafer.

The SOI wafer manufactured by the above-explained SOI wafer manufacturing method has a high flatness and a high quality with a uniformed in-plane film thickness.

Like the present invention, according to the method of manufacturing an SOI wafer by the ion implantation delamination method, when bonding is carried out through the oxide film and delamination is performed in the ion implanted layer to form the oxide film on the surface of the SOI layer and the oxide film is removed by etching and then the surface of the SOI layer is cleaned by using the ozone water and thereafter is polished, a damaged layer and surface roughness remaining on the SOI layer surface after delamination can be removed while maintaining film thickness uniformity of the SOI layer, and the high-quality SOI wafer can be obtained without degrading the film thickness uniformity even though the surface of the SOI layer is polished in particular. Further, therefore, a yield and productivity in wafer manufacture can be improved.

### Brief Explanation of the Drawings

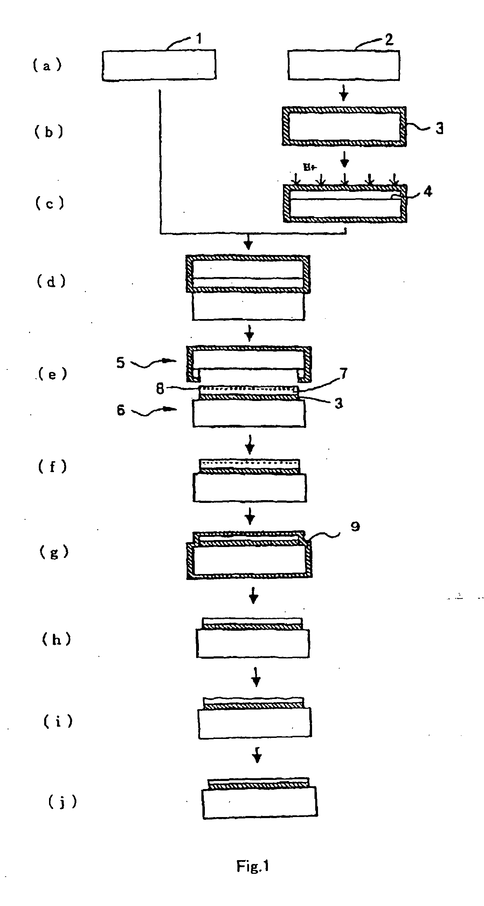

FIG. 1 is a schematic process drawing showing an example of manufacturing steps in a method of manufacturing an SOI wafer by an ion implantation delamination method.

### Best Mode for Carrying out the Invention

Although an embodiment according to the present invention will now be explained hereinafter, the present invention is not restricted thereto.
Here, FIG. 1 is a schematic process drawing showing an example of manufacturing steps in a method of manufacturing an SOI wafer by an ion implantation delamination method according to the present invention.
The present invention will be explained mainly by an example where two silicon wafers are bonded. First, in the ion implantation delamination method depicted in FIG. 1, at a step (a), two silicon mirror-surface wafers are prepared, and a base wafer 1 serving as a support substrate and a bond wafer 2 functioning as an SOI layer meeting device specifications are prepared.

Then, at a step (b), at least one of the wafers, e.g., the bond wafer 2 is subjected to thermal oxidation or the like to form an oxide film 3 having a thickness of approximately 0.1 to 2.0 µm on a surface of this wafer.
At a step (c), at least one of a hydrogen ion and a rare gas ion, e.g., the hydrogen ion in this example is implanted into one side of the bond wafer 2 having the oxide film formed thereon to form an ion implanted layer 4 which is in parallel with the surface in an average penetration depth of the ion.

A step (d) is a step of superimposing the base wafer 1 to be appressed against the hydrogen ion implanted surface of the bond wafer 2 having the hydrogen ion implanted therein via the oxide film, bringing the surfaces of the two wafers into contact with each other in a clean atmosphere at a room temperature enables to bond the wafers without using, e.g., an adhesive.

Subsequently, a step (e) is a delamination heat treatment step of conducting delamination with the ion implanted layer 4 being determined as a boundary to separate the wafers into a delaminated wafer 5 and an SOI wafer 6 (an SOI layer 7 + the buried oxide film 3 + the base wafer 1). When the heat treatment is performed at a temperature of approximately 500°C or more in, e.g., an inert gas atmosphere, the wafers can be separated into the delaminated wafer 5 and the SOI wafer 6 by rearrangement of crystal and agglomeration of air bubbles. Furthermore, a damaged layer 8 remains on the SOI layer 7 provided on the delaminated SOI wafer surface.

After the delamination step, a bonding heat treatment step is carried out at a step (f). At this step, since a bonding strength of the wafers appressed against each other in the close contact step and the delamination heat treatment step at the steps (d) and (e) is too weak to be used in a device process as it is, a high-temperature heat treatment is carried out with respect to the SOI wafer 6 as a bonding heat treatment to provide sufficient bonding strength. It is preferable to carry out this heat treatment in, e.g., an inert gas atmosphere at 1000 to 1300°C in the range of 30 minutes to two hours.
In this case, the delamination heat treatment is performed at a high temperature, e.g., 800°C or more so that this heat treatment also serves as the bonding heat treatment, and the bonding heat treatment which is solely performed may be omitted.

Moreover, at a step (g), a heat treatment in an oxidizing atmosphere is first conducted to form an oxide film 9 on the SOI layer 7, thereby taking the damaged layer 8 into the oxide film 9.
Additionally, at a step (h), the oxide film 9 formed on the SOI layer 7 is removed. This removal of the oxide film 9 can be performed by conducting etching with an aqueous solution containing a hydrogen fluoride. When a hydrofluoric acid treatment is carried out in this manner, the oxide film 9 alone is removed by etching, and the SOI wafer 6 from which the damaged layer is removed by sacrificial oxidation can be obtained. Further, such a hydrofluoric acid treatment with respect to the wafer is easy and also has an advantage of a low cost.

Furthermore, at a step (i), cleaning using ozone water is carried out. When ozone water cleaning is added after the hydrofluoric acid treatment, removal of a metal impurity is further promoted by a strong oxidizing power of the ozone, and the metal impurity can be prevented from again adhering to the wafer outer surface. That is, since the ozone water demonstrates an oxidation-reduction potential higher than that of a hydrogen peroxide, it can be considered that the ozone water has the higher oxidizing power and strongly ionizes an impurity, especially a metal element, thereby preventing the impurity from adhering to the substrate surface. Moreover, as compared with generally adopted SC-2 cleaning, cleaning using the ozone water has a tendency that a flatness of a native oxide film on the surface is degraded, but this has the opposite effect that a polishing agent spreads on the entire wafer surface at the next polishing step, e.g., touch polishing, thus improving the flatness and a film thickness distribution of the SOI layer after touch polishing. Although cleaning the SOI layer so as not to degrade the flatness as much as possible is a common practice in the conventional example, it was revealed that the polishing agent spreads when the native oxide film on the surface has appropriate roughness in case of performing subsequent polishing, thereby assuring the flatness and film thickness uniformity of the surface of the SOI layer after polishing.

Additionally, it is preferable for an ozone water concentration in this time to be, e.g., 3 ppm or more and 10 ppm or less. When the ozone water concentration is 10 ppm or less, the surface roughness of the native oxide film on the SOI layer before polishing can be appropriately degraded, and the film thickness distribution of the native oxide film of the SOI layer surface can become uneven. When the film thickness distribution of the native oxide film on the surface is made uneven before polishing in this manner, a polishing step (j) by, e.g., touch polishing after ozone water cleaning enables to make the film thickness distribution of the SOI layer after polishing more uniform as compared with the conventional method. However, in case of the ozone water concentration which is less than 3 ppm, a cleaning effect is reduced, and the above-explained effect is also decreased.

According to such an SOI wafer manufacturing method of the present invention, the high-quality SOI wafer having a more excellent SOI layer film thickness distribution can be efficiently produced.

### (Example 1)

The steps were carried out as depicted in FIG. 1 to obtain 16 SOI wafers each having a diameter of 300 mm. At this time, a hydrofluoric acid treatment was performed at 22°C for 60 seconds, and ozone cleaning was conducted with a concentration of 10 ppm for 60 seconds. Measuring a thickness of a native oxide film on an SOI layer surface of each wafer at 9 positions within the plane after ozone cleaning, a P-V value (a difference between a maximum value and a minimum value) of the film thickness of the native oxide film was 0.1441 nm, and a standard deviation had a value of 0.0522. Then, touch polishing with a removal stock of 30 nm was performed with respect to the surface of the SOI layer, then a thickness of the SOI layer at a point which is 3 mm or less apart from an outer periphery of each wafer was measured at approximately 4000 positions, an average value of P-V values (the difference between a maximum value and a minimum value) of the SOI layer film thicknesses of the 16 wafers was 5.81 nm, and a standard deviation of the SOI layer film thickness itself was 0.80. Table 1 shows this result.

**[Table 1]**

| | P-V value of SOI layer film thickness (nm) | Standard deviation of SOI layer film thickness |
|---|---|---|
| 1 | 5.9 | 0.68 |
| 2 | 6.9 | 0.89 |
| 3 | 7.7 | 0.94 |
| 4 | 3.9 | 0.46 |
| 5 | 6.2 | 1.08 |
| 6 | 5.3 | 0.74 |
| 7 | 6.4 | 0.87 |
| 8 | 5.5 | 0.69 |
| 9 | 4.6 | 0.77 |
| 10 | 6.8 | 0.75 |
| 11 | 6.5 | 0.84 |
| 12 | 4.9 | 0.85 |
| 13 | 5.5 | 0.83 |
| 14 | 6.0 | 0.92 |
| 15 | 4.8 | 0.76 |
| 16 | 6.1 | 0.71 |
| Average value | 5.81 | 0.80 |

### (Comparative Example 1)

Then, as a comparative example, SC-2 cleaning was carried out at the step (i) depicted in FIG. 1 like a conventional example in place of ozone water cleaning, thereby obtaining 10 SOI wafers each having a diameter of 300 mm. At this time, conditions of a hydrofluoric acid treatment were the same as those in Example, and SC-2 cleaning was performed at 80°C for 180 seconds. Measuring a thickness of a native oxide film on an SOI layer surface after SC-2 cleaning like Example 1, a P-V value was 0.0154 nm, a standard deviation was 0.0047, and they were better values than those in Examples (including the following Examples 2 and 3 explained below). Subsequently, when touch polishing with a removal stock of 30 nm was performed with respect to the surface of the SOI layer and then an SOI layer film thickness was measured like Example 1, an average value of P-V values of the SOI layer film thicknesses of the 10 wafers was 8.23 nm, a standard deviation of the SOI layer film thickness itself was 1.12, and it was confirmed that these values were worse than those in Examples 1 to 3.

**[Table 2]**

| | P-V value of SOI layer film thickness (nm) | Standard deviation of SOI layer film thickness |
|---|---|---|
| 1 | 7.1 | 1.01 |
| 2 | 8.4 | 1.11 |
| 3 | 9.2 | 1.23 |
| 4 | 8.3 | 1.12 |
| 5 | 7.2 | 1.03 |
| 6 | 9.2 | 1.13 |
| 7 | 7.9 | 1.05 |
| 8 | 8.3 | 1.20 |
| 9 | 9.3 | 1.22 |
| 10 | 7.4 | 1.12 |
| Average value | 8.23 | 1.12 |

### (Examples 2 and 3)

The same steps as those in Example 1 were carried out with respect to 10 wafers except that an ozone concentration in ozone water was set to 15 ppm (Example 2) or 20 ppm (Example 3) at the ozone cleaning step. At this time, a P-V value of a native oxide film thickness on an SOI layer surface of each wafer after ozone cleaning was 0.1693 nm or 0.1885 nm, a standard deviation was 0.0627 or 0.0734, and these values were higher than those of Example 1 and Comparative Example 1 after ozone cleaning. Furthermore, after touch polishing with respect to the surface of the SOI layer, a P-V value of an SOI layer film thickness was 6.21 nm or 6.83 nm, a standard deviation of the SOI layer film thickness itself was 0.86 or 0.93, and these values were higher than those in Example 1 but lower than those in Comparative Example 1, thereby obtaining the wafers having with the quality higher than Comparative Example 1.

It is to be noted that the present invention is not restricted to the foregoing embodiment. The embodiment is just an example, and any example which has a structure substantially equal to a technical concept described in claims of the present invention and demonstrates the same functions and effects is included in a technical scope of the present invention.

## Claims

1. A manufacturing method of an SOI wafer by an ion implantation delamination method, comprising at least:
forming an oxide film on a surface of at least one of a base wafer serving as a support substrate and a bond wafer functioning as an SOI layer; implanting at least one of a hydrogen ion and a rare gas ion from a surface of the bond wafer to form an ion implanted layer; subsequently bringing the bond wafer into close contact with the base wafer via the oxide film; performing a heat treatment to cause delamination in the ion implanted layer so that the SOI layer is formed; then conducting a heat treatment in an oxidizing atmosphere to form an oxide film on the surface of the SOI layer; subsequently removing the oxide film by etching; then cleaning the surface of the SOI layer by using ozone water; and polishing the surface of the SOI layer.

2. The manufacturing method of an SOI wafer according to claim 1, wherein a heat treatment to increase bonding strength is carried out at a temperature higher than that in the delamination heat treatment after the delamination heat treatment.

3. The manufacturing method of an SOI wafer according to claim 1 or 2, wherein the removal of the oxide film by the etching is performed by using an aqueous solution containing a hydrogen fluoride.

4. The manufacturing method of an SOI wafer according to any one of claims 1 to 3, wherein an ozone concentration in the ozone water is 3 ppm or more and 10 ppm or less.

5. The manufacturing method of an SOI wafer according to any one of claims 1 to 4, wherein the polishing is carried out by touch polishing.

## Patentansprüche

1. Verfahren zur Herstellung eines SOI-Wafers durch ein Ionen-Implantations-Delaminations-Verfahren, umfassend zumindest: Bilden eines Oxidfilms auf einer Oberfläche von zumindest einem von einem Basiswafer, der als ein Trägersubstrat dient, und einem Bindungswafer, der als eine SOI-Schicht dient; Implantieren von zumindest einem von einem Wasserstoff-Ion und einem Edelgas-Ion von einer Oberfläche des Bindungswafers, um eine Ionen-implantierte Schicht zu bilden; Nachfolgend, in nahen Kontakt bringen des Bindungswafers mit dem Basiswafer über den Oxidfilm; Durchführen einer Wärmebehandlung um Delamination in der Ionen-Implantierten Schicht zu bewirken, sodass die SOI-Schicht gebildet wird; Dann durchführen einer Wärmebehandlung in einer oxidierenden Atmosphäre, um einen Oxidfilm auf der Oberfläche der SOI-Schicht zu bilden; Nachfolgend, entfernen des Oxidfilms durch Ätzen; Dann reinigen der Oberfläche der SOI-Schicht unter Verwendung von Ozon-Wasser; Und polieren der Oberfläche der SOI-Schicht.

2. Das Verfahren zur Herstellung eines SOI-Wafers nach Anspruch 1, wobei eine Wärmebehandlung zur Erhöhung der Bindungsstärke nach der Delaminations-Wärmebehandlung bei einer Temperatur durchgeführt wird, die höher ist, als in der Delaminations-Wärmebehandlung.

3. Das Verfahren zur Herstellung eines SOI-Wafers nach Anspruch 1 oder 2, wobei das Entfernen des Oxidfilms durch das Ätzen unter Verwendung einer wässrigen Lösung enthaltend ein Wasserstofffluorid ausgeführt wird.

4. Das Verfahren zur Herstellung eines SOI-Wafers nach einem der Ansprüche 1 bis 3, wobei eine Ozonkonzentration in dem Ozon-Wasser 3 ppm oder mehr und 10 ppm oder weniger beträgt.

5. Das Verfahren zur Herstellung eines SOI-Wafers nach einem der Ansprüche 1 bis 4, wobei das Polieren durch Kontaktpolieren erfolgt.

## Revendications

1. Procédé de fabrication d'une plaquette SOI par un procédé de décollement par implantation ionique, comprenant au moins les étapes consistant à :
former un film d'oxyde sur une surface d'au moins l'une parmi une plaquette de base servant de substrat de support et une plaquette de liaison fonctionnant comme une couche SOI ; implanter au moins l'un parmi un ion d'hydrogène et un ion de gaz rare à partir d'une surface de la plaquette de liaison pour former une couche à ions implantés ; par la suite amener la plaquette de liaison en contact étroit avec la plaquette de base via le film d'oxyde ; réaliser un traitement thermique pour provoquer un décollement dans la couche à ions implantés de sorte que la couche SOI est formée ; ensuite mener un traitement thermique dans une atmosphère d'oxydation pour former un film d'oxyde sur la surface de la couche SOI ; par la suite enlever le film d'oxyde par attaque chimique ; puis nettoyer la surface de la couche SOI en utilisant de l'eau ozonisée ; et polir la surface de la couche SOI.

2. Procédé de fabrication d'une plaquette SOI selon la revendication 1, dans lequel un traitement thermique pour augmenter le pouvoir de liaison est réalisé à une température supérieure à celle dans le traitement thermique de décollement après le traitement thermique de décollement.

3. Procédé de fabrication d'une plaquette SOI selon la revendication 1 ou 2, dans lequel l'enlèvement du film d'oxyde par l'attaque chimique est réalisé en utilisant une solution aqueuse contenant un fluorure d'hydrogène.

4. Procédé de fabrication d'une plaquette SOI selon l'une quelconque des revendications 1 à 3, dans lequel une concentration en ozone dans l'eau ozonisée est de 3 ppm ou plus et 10 ppm ou moins.

5. Procédé de fabrication d'une plaquette SOI selon l'une quelconque des revendications 1 à 4, dans lequel le polissage est réalisé par polissage par effleurement.
